# DEMANDE DE BREVET EUROPEEN

(11) **EP 4 583 662 A1**
(43) Date de publication de la demande: **09.07.2025**
(21) Numéro de dépôt: 25150124.3
(22) Date de dépôt: 02.01.2025
(51) Int. Cl.: H10B 63/00, H10B 63/10, H10N 70/00, H10N 70/20

(54) **DISPOSITIF ELECTRONIQUE**

(30) Priorité: 02.01.2024 FR 2400012
(71) Demandeur: STMicroelectronics International N.V., 1228 Plan-les-Ouates, Geneva (CH)
(72) Inventeur: FAVENNEC, Laurent, 38190 VILLARD BONNOT (FR); JEANNOT, Simon, 38000 GRENOBLE (FR); GIRAUDIN, Jean-Christophe, 38330 SAINT-NAZAIRE-LES-EYMES (FR)
(74) Mandataire: Cabinet Beaumont

(57) **Abrégé**

La présente description concerne un dispositif électronique (11) comprenant :
- un substrat semiconducteur (13) dans lequel sont disposés des transistors de sélection ;
- un premier empilement d'interconnexion (35) comportant au moins un niveau comportant des première et deuxième couches isolantes (37, 39), dans lesquels sont définis des pistes conductrices (71) et des premiers vias conducteurs (69) ;
- une troisième couche isolante (45), reposant sur le premier empilement ;
- un deuxième empilement d'interconnexion (36), comportant au moins un niveau comportant des première et deuxième couches isolantes (37, 39) ;
- une pluralité de cellules mémoires (M) disposées dans la troisième couche isolante (45) ; et
- au moins un deuxième via conducteur (70) s'étendant sur toute la hauteur de la troisième couche isolante.

## Description

### Domaine technique

La présente description concerne de façon générale le domaine des dispositifs électroniques et vise plus particulièrement le domaine des dispositifs électroniques comportant un circuit mémoire à base d'un matériau à changement de phase et leurs procédés de fabrication.

### Technique antérieure

Un matériau à changement de phase est un matériau ayant la capacité de changer d'état cristallin sous l'effet de la chaleur et plus particulièrement de commuter entre un état cristallin et un état amorphe, plus fortement résistif que l'état cristallin. Ce phénomène est utilisé pour définir deux états mémoires, par exemple 0 et 1, différenciés par la résistance mesurée à travers le matériau à changement de phase.

Il existe un besoin d'amélioration des puces électroniques comportant un circuit mémoire comportant des cellules mémoires à base d'un matériau à changement de phase, et de leurs procédés de fabrication.

### Résumé de l'invention

Un mode de réalisation prévoit un dispositif électronique comprenant :
- un substrat semiconducteur dans lequel sont disposés des transistors de sélection ;
- un premier empilement d'interconnexion, disposé sur le substrat semiconducteur, comportant au moins un niveau, chaque niveau comportant des première et deuxième couches isolantes, dans lesquels sont définis des pistes conductrices et des premiers vias conducteurs ;
- une troisième couche isolante, reposant sur le premier empilement d'interconnexion ;
- un deuxième empilement d'interconnexion, disposé sur la troisième couche isolante, comportant au moins un niveau, chaque niveau comportant des première et deuxième couches isolantes, dans lesquels sont définis les pistes conductrices et les premiers vias conducteurs ;
- une pluralité de cellules mémoires disposées dans la troisième couche isolante ; et
- au moins un deuxième via conducteur s'étendant sur toute la hauteur de la troisième couche isolante, de manière à relier les pistes conductrices et les premiers vias conducteurs des premier et deuxième empilements.

Selon un mode de réalisation, chaque cellule mémoire comprend un élément résistif en contact avec une quatrième couche en un matériau à changement de phase, la septième couche étant surmonté par une cinquième couche conductrice.

Selon un mode de réalisation, le substrat semiconducteur comprend, à partir d'une face supérieure, une sixième couche semiconductrice dopée d'un premier type de conductivité, située sur et en contact avec une septième couche semiconductrice dopée d'un deuxième type de conductivité opposé au premier type de conductivité.

Selon un mode de réalisation, le substrat semiconducteur est surmonté par une huitième couche semiconductrice comportant des premières zones dopées du deuxième type de conductivité, chacune des premières zones de la huitième couche semiconductrice étant reliée à une cellule mémoire.

Selon un mode de réalisation, la sixième couche semiconductrice, la septième couche semiconductrice et les premières zones de la sixième couche semiconductrice constituent les transistors de sélection.

Selon un mode de réalisation, la huitième couche semiconductrice comporte des deuxièmes zones dopées du premier type de conductivité, chacune des deuxièmes zones de la huitième couche semiconductrice étant reliée à un ensemble de premiers vias conducteurs et de pistes conductrices traversant l'empilement d'interconnexion.

Selon un mode de réalisation, chacune des premières zones de la huitième couche semiconductrice est reliée à une cellule mémoire par un unique troisième via s'étendant sur toute la hauteur du premier empilement.

Selon un mode de réalisation, chaque troisième via est en contact avec l'élément résistif de la cellule mémoire.

Selon un mode de réalisation, chacune des premières zones de la huitième couche semiconductrice est reliée à une cellule mémoire par des vias conducteurs et des pistes conductrices du premier réseau d'interconnexion et par un quatrième via s'étendant dans la troisième couche et étant en contact avec l'élément résistif de la cellule mémoire, chaque quatrième via étant en le même matériau que les deuxièmes vias.

Selon un mode de réalisation, la troisième couche est en un matériau différent des matériaux des première et deuxième couches isolantes.

Selon un mode de réalisation, le matériau de la troisième couche a une constante diélectrique supérieure à ceux des matériaux des premières et deuxièmes couches.

Selon un mode de réalisation, la hauteur de la troisième couche est supérieure aux hauteurs des niveaux des premier et deuxième empilements.

Selon un mode de réalisation, le niveau du deuxième empilement le plus proche de la troisième couche comprend uniquement des pistes conductrices en contact avec le troisième via.

Selon un mode de réalisation, les pistes conductrices des premier et deuxième empilements s'étendent latéralement sur une surface supérieure à la surface des premiers vias conducteurs du même niveau.

Un autre mode de réalisation prévoit un procédé de fabrication d'un dispositif électronique comprenant :
- la formation d'un substrat semiconducteur dans lequel sont disposés des transistors de sélection ;
- la formation d'un premier empilement d'interconnexion, disposé sur le substrat semiconducteur, comportant au moins un niveau, chaque niveau comportant des première et deuxième couches isolantes, dans lesquels sont définis des pistes conductrices et des premiers vias conducteurs ;
- la formation d'une troisième couche isolante, reposant sur le premier empilement d'interconnexion ;
- la formation d'une pluralité de cellules mémoires disposées dans la troisième couche isolante ;
- la formation d'un deuxième empilement d'interconnexion, disposé sur la troisième couche isolante, comportant au moins un niveau, chaque niveau comportant des première et deuxième couches isolantes, dans lesquels sont définis les pistes conductrices et les premiers vias conducteurs ; et
- la formation d'au moins un deuxième via conducteur s'étendant sur toute la hauteur de la troisième couche, de manière à relier les pistes conductrices et les premiers vias conducteurs des premier et deuxième empilements.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B illustrent deux vues en coupe, partielles et schématiques, d'un dispositif électronique selon un mode de réalisation ;
la figure 2A, la figure 2B, la figure 2C, la figure 2D, la figure 2E, la figure 2F, la figure 2G, la figure 2H, la figure 2I, la figure 2J, la figure 2K, la figure 2L, la figure 2M, la figure 2N, la figure 2O et la figure 2P représentent des étapes d'un exemple de procédé de fabrication du dispositif électronique illustré en figure 1A et en figure 1B ;
la figure 3 représente un dispositif électronique selon un autre mode de réalisation ; et
la figure 4 représente un dispositif électronique selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

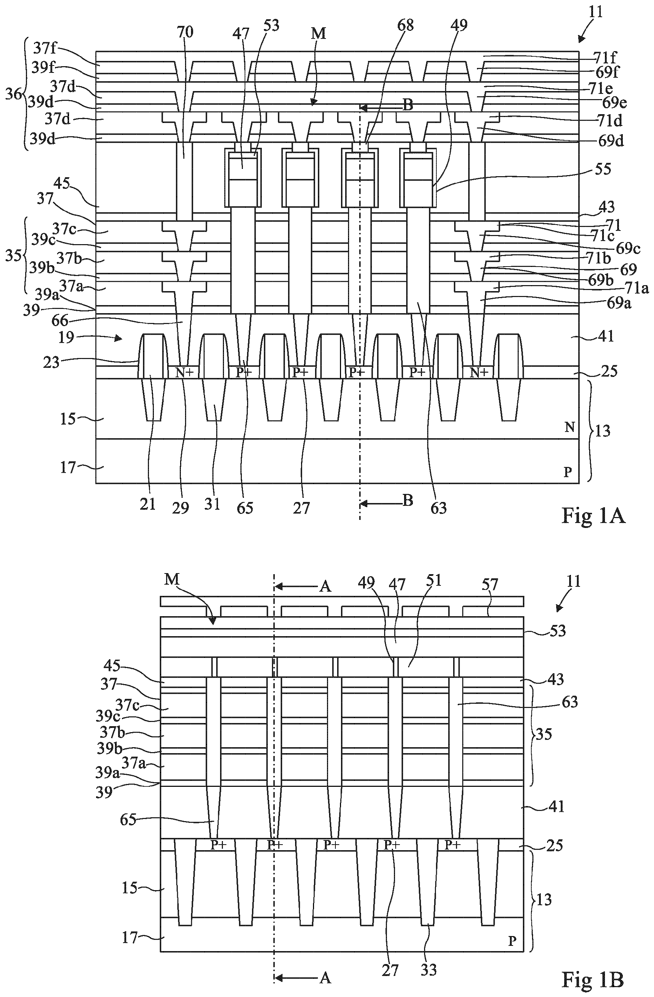

La figure 1A et la figure 1B illustrent deux vues en coupe, partielles et schématiques, d'un dispositif électronique 11, par exemple une puce électronique, selon un mode de réalisation. La figure 1A est une vue selon le plan de coupe AA de la figure 1B et la figure 1B est une vue selon le plan de coupe BB de la figure 1A.

Plus particulièrement, la figure 1A et la figure 1B illustrent une portion d'un circuit mémoire de la puce électronique 11. A titre d'exemple, la puce électronique 11 comprend, dans une portion non représentée, un circuit logique adjacent au circuit mémoire. Les circuits logique et mémoire sont, par exemple, fabriqués simultanément dans et sur un même substrat semiconducteur.

La puce électronique comprend un substrat semiconducteur 13. A titre d'exemple, le substrat 13 est en silicium.

Le substrat 13 comprend, par exemple, une couche semiconductrice 15 dopée d'un premier type de conductivité, par exemple du type N, par exemple dopée d'atomes d'arsenic ou de phosphore. La couche 15 repose, par exemple, sur une autre couche semiconductrice 17 du substrat 13 dopée d'un deuxième type de conductivité, opposé au premier type de conductivité, par exemple du type P, par exemple dopée d'atomes de bore.

A titre d'exemple, la puce 11 comprend des motifs de grille 19 (en anglais "dummy gate") disposés sur la face supérieure de la couche 15, par exemple s'étendant longitudinalement dans une première direction. Les motifs de grille 19 comportent, par exemple une partie centrale 21 entourée latéralement d'espaceurs 23. La partie centrale 21 de chaque motif de grille 19 est, par exemple en un matériau semiconducteur, par exemple en silicium, par exemple en silicium polycristallin. Les espaceurs 23 sont par exemple en un matériau isolant électriquement, par exemple en un nitrure de silicium.

Les motifs de grille 19 sont, par exemple, séparés latéralement par une couche semiconductrice 25, par exemple formée par épitaxie à partir de la face supérieure de la couche 15. La couche 25 est, par exemple en silicium, par exemple en silicium monocristallin.

La couche 25 comprend, par exemple, des premières régions 27, par exemple dopées du deuxième type de conductivité, par exemple du type P, et s'étendant entre certains motifs de grille 19. Les régions 27 sont, par exemple plus fortement dopées que la couche 17. Chaque région 27 est, par exemple surmontée d'une cellule mémoire M.

Les cellules mémoires M sont par exemple organisées, en vue de dessus, selon une matrice de lignes et de colonnes. On parle respectivement de lignes de mots (wordlines) et de lignes de bits (bitlines), chaque cellule mémoire M étant située à l'intersection d'une ligne de bits et d'une ligne de mots. A titre d'exemple, les cellules mémoires M illustrées en figure 1A sont des cellules mémoires M d'une même ligne de mots alors que les cellules mémoires illustrées en figure 1B sont des cellules mémoires d'une même ligne de bits. Dans l'exemple de la figure 1A, les motifs de grille 19 s'étendent dans la même direction que les cellules mémoires M illustrées en figure 1A, c'est-à-dire dans la direction des lignes de bits. Dans cet exemple, les motifs de grille 19 s'étendent, en vue de dessus, entre les régions 27 de la couche 25. Autrement dit, dans cet exemple, en vue de dessus, deux régions 27 consécutives quelconques sont séparées l'une de l'autre par un et un seul motif de grille 19 s'étendant sur toute la longueur desdites lignes de bits. En figure 1A, seulement quatre lignes de bits sont représentées et en figure 1B seulement cinq lignes de mots sont représentées. Toutefois, en pratique, un circuit mémoire peut comprend un nombre de lignes de bits et de lignes de mots différent respectivement de quatre et cinq, par exemple supérieur à quatre et cinq.

La couche 25 comprend, en outre, des deuxièmes régions 29, par exemple dopées du premier type de conductivité, par exemple du type N, et s'étendant entre d'autres motifs de grille 19. Les régions 29 sont, par exemple, plus fortement dopées que la couche 15. Les régions 29, à la différence des régions 27, ne sont pas surmontées de cellules mémoires M.

Les régions 29 et 27 sont, par exemple, délimitées latéralement, dans la direction des lignes de mots, par les motifs de grille 19 et par des premières tranchées d'isolation 31, par exemple des tranchées d'isolation très peu profondes (SSTI, de l'anglais "Super Shallow Trench Isolation"). Les premières tranchées d'isolation 31 empêchent, par exemple, des fuites de courant électrique entre deux lignes de bits successives. Les premières tranchées 31 sont, par exemple, situées sous les motifs de grille 19. A titre d'exemple, les premières tranchées 31 sont linéaires et chaque motif de grille 19 est situé sur et en contact avec une première tranchée 31. A titre d'exemple, chaque première tranchée 31 s'étend longitudinalement dans la direction des lignes de bits, sur toute la longueur des lignes de bits. A titre d'exemple, les premières tranchées 31 s'étendent, verticalement, dans la couche 15, à partir de la face supérieure de la couche 15 sur une partie seulement de l'épaisseur de la couche 15. Les premières tranchées d'isolation 31 sont par exemple remplies d'un matériau diélectrique, par exemple de l'oxyde de silicium. La profondeur des premières tranchées 31 est par exemple comprise entre 20 nm et 40 nm.

A titre d'exemple, la puce 11 comprend des deuxièmes tranchées d'isolation 33, par exemple des tranchées d'isolation peu profondes (STI, de l'anglais "Shallow Trench Isolation"). Les tranchées d'isolation 31 et les tranchées d'isolation 33 sont, par exemple, orthogonales et forment une grille. La profondeur des tranchées d'isolation 33 est par exemple supérieure à la profondeur des tranchées d'isolation 31. Les tranchées d'isolation 33 s'étendent, par exemple, à partir de la face supérieure de la couche 15, dans la couche 15 et dans une partie de la couche 17. A titre d'exemple, les tranchées d'isolation 33 permettent de séparer et donc d'isoler électriquement des bandes de la couche 15 à l'aplomb respectivement de chaque ligne de mots. A titre d'exemple, chaque tranchée d'isolation 33 s'étend longitudinalement dans la direction des lignes de mots, sur toute la longueur des lignes de mots. Les tranchées d'isolation 33 sont par exemple remplies d'un matériau diélectrique, par exemple de l'oxyde de silicium. La profondeur des tranchées 33 est par exemple comprise entre 300 nm et 400 nm.

Dans l'exemple des figures 1A et 1B, la structure formée par les couches 15, 17 et 21 et les motifs de grille 19 est surmontée d'un empilement, ou réseau, d'interconnexion. L'empilement d'interconnexion est divisé en deux parties : un premier empilement d'interconnexion 35 et un deuxième empilement d'interconnexion 36. Dans cet exemple, l'empilement d'interconnexion 35 est formé entre le substrat 13 et les cellules mémoires M. L'empilement d'interconnexion s'étend par exemple sur l'ensemble de la puce 11. L'empilement d'interconnexion 35 est par exemple formé d'une succession de niveaux, chaque niveau comportant une couche isolante 37 et couche isolante 39. Les couches 37 et 39 sont par exemple en des matériaux différents.

L'empilement d'interconnexion 35 est par exemple formé sur une couche isolante 41 recouvrant la face supérieure de la couche 25 et la face supérieure des motifs de grille 19. La couche 41 s'étend par exemple sur toute la puce 11. La couche isolante 41 est par exemple en contact avec la face supérieure de la couche 25 et des motifs de grille 19. La couche isolante 41 recouvre par exemple l'ensemble de la face supérieure de la couche 25. La couche isolante 41 a par exemple une épaisseur comprise entre 120 nm et 200 nm, par exemple comprise entre 140 nm et 180 nm.

L'empilement d'interconnexion 35 est par exemple formé sur la face supérieure de la couche isolante 41 et recouvre par exemple toute la surface de la couche isolante 41. L'empilement d'interconnexion 35 comprend par exemple une couche isolante 39a formée sur et en contact avec la face supérieure de la couche isolante 41. L'empilement d'interconnexion 35 comprend en outre une couche isolante 37a formée sur la couche isolante 39a. La couche isolante 37a est par exemple formée sur toute la surface de la couche isolante 39a. A titre d'exemple, la couche isolante 37a est en contact, par sa face inférieure, avec la face supérieure de la couche isolante 39a. Les couches 39a et 37a forment un niveau de l'empilement d'interconnexion.

L'empilement d'interconnexion 35 peut en outre comprendre des niveaux supplémentaires formés sur et en contact avec la couche isolante 37a. En figures 1A et 1B, l'empilement d'interconnexion 35 comprend deux niveaux supplémentaires par exemple formés respectivement des couches 37b et 39b et des couches 37c et 39c. En pratique, le nombre de niveaux dans l'empilement d'interconnexion 35 peut être différent de trois, par exemple supérieur à trois.

A titre d'exemple, l'empilement d'interconnexion 35 a une épaisseur comprise entre 100 nm et 600 nm, par exemple comprise entre 200 nm et 500 nm, par exemple de l'ordre de 300 nm. Par exemple, les niveaux de l'empilement d'interconnexion ont sensiblement la même épaisseur.

L'empilement d'interconnexion 35 est par exemple surmonté d'une couche isolante 43. La couche isolante 43 est par exemple formée sur et en contact avec l'empilement d'interconnexion 35 et plus particulièrement sur et en contact avec la couche isolante 37c. La couche isolante 43 s'étend par exemple sur l'ensemble de la surface de l'empilement d'interconnexion 35.

A titre d'exemple, les couches isolantes 41 et 37 sont en un matériau de faible constante diélectrique, par exemple en un matériau ayant une constante diélectrique (correspondant à la permittivité dudit matériau par rapport à la permittivité du vide), inférieure à 5, par exemple inférieure à 4. Les couches isolantes 37 sont par exemple en SiOCH ou en SiOCH poreux. A titre d'exemple, les couches isolantes 39 et 43 sont en carbonitrure de silicium (SiCN), en nitrure de silicium (SiN) ou en SiCH.

La couche isolante 43 est par exemple surmontée par une couche isolante 45. La couche 45 est par exemple en un unique matériau. La couche 45 est par exemple en un matériau homogène. La couche isolante 45 est par exemple en un matériau différent du matériau des couches 37. La couche isolante est par exemple en un matériau différent du matériau des couches 39 et 43. La couche isolante 45 est par exemple en un matériau ayant une constante diélectrique supérieure à 3,7, ou en dioxyde de silicium (SiO₂). A titre d'exemple, la couche isolante 45 est formée sur et en contact avec la face supérieure de la couche isolante 43. La couche 45 a par exemple une épaisseur supérieure à l'épaisseur des niveaux de l'empilement d'interconnexion, par exemple de tous les niveaux de l'empilement 35. La couche 45 a par exemple une épaisseur sensiblement constante. L'épaisseur de la couche 45 est par exemple comprise entre 160 nm et 500 nm, par exemple entre 180 nm et 240 nm. La couche 45 s'étend de préférence sur l'ensemble de la puce, y compris sur les régions de la puce comprenant des circuits logiques.

La couche 45 est recouverte, de préférence entièrement recouverte, par l'empilement d'interconnexion 36. Ainsi, l'empilement d'interconnexion 35 est par exemple formé sur la couche 45, par exemple sur les mémoires M. L'empilement d'interconnexion 36 s'étend par exemple sur l'ensemble de la puce 11. L'empilement d'interconnexion 36 est par exemple formé d'une succession de niveaux, chaque niveau comportant une couche isolante 37 et couche isolante 39.

L'empilement d'interconnexion 36 est par exemple formé sur une couche isolante 45 et recouvre par exemple toute la surface de la couche isolante 45. L'empilement d'interconnexion 36 comprend par exemple une couche isolante 39d formée sur et en contact avec la face supérieure de la couche isolante 45. L'empilement d'interconnexion 36 comprend en outre une couche isolante 37d formée sur la couche isolante 39d. La couche isolante 37d est par exemple formée sur toute la surface de la couche isolante 39d. A titre d'exemple, la couche isolante 37d est en contact, par sa face inférieure, avec la face supérieure de la couche isolante 39d. Les couches 39d et 37d forment un niveau de l'empilement d'interconnexion 36.

L'empilement d'interconnexion 36 peut par exemple comprendre des niveaux supplémentaires formés sur et en contact avec la couche isolante 37d. En figures 1A et 1B, l'empilement d'interconnexion 36 comprend deux niveaux supplémentaires par exemple formés respectivement des couches 37e et 39e et des couches 37f et 39f. En pratique, le nombre de niveaux dans l'empilement d'interconnexion 36 peut être différent de trois, par exemple supérieur ou égal à un.

A titre d'exemple, l'empilement d'interconnexion 36 a une épaisseur comprise entre 100 nm et 600 nm, par exemple comprise entre 200 nm et 500 nm, par exemple de l'ordre de 300 nm. Par exemple, les niveaux de l'empilement d'interconnexion ont sensiblement la même épaisseur, par exemple la même épaisseur que les niveaux de l'empilement d'interconnexion 35.

A titre d'exemple, les couches isolantes 37 de l'empilement 36 sont en un matériau de faible constante diélectrique, par exemple en un matériau ayant une constante diélectrique (correspondant à la permittivité dudit matériau par rapport à la permittivité du vide), inférieure à 5, par exemple inférieure à 4. Les couches isolantes 37 sont par exemple en SiOCH ou en SiOCH poreux. A titre d'exemple, les couches isolantes 39 sont en carbonitrure de silicium (SiCN), en nitrure de silicium (SiN) ou en SiCH.

Les cellules mémoires M sont formées dans la couche isolante 45. De préférence, les cellules mémoires sont entièrement situées dans la couche 45.

A titre d'exemple, chaque cellule mémoire M comprend une couche 47 en un matériau à changement de phase, par exemple un matériau chalcogènure, par exemple un alliage de germanium, antimoine et tellure (GeSbTe) dit GST. La couche 47 constitue un élément résistif à résistance variable. La couche 47 en matériau à changement de phase a, par exemple une épaisseur comprise entre 30 nm et 100 nm, par exemple, de l'ordre de 50 nm. Dans le mode de réalisation des figures 1A et 1B, les cellules M d'une même ligne de bits, de préférence toutes les cellules M d'une même ligne de bits, comprennent une couche 47 commune. La couche 47 s'étend ainsi, dans la couche 45, dans la direction des lignes de bits.

Dans chaque cellule mémoire M, la couche 47 est, par exemple, contrôlé par un élément résistif métallique chauffant 49 situé sous la couche 47, par exemple en contact, par sa face supérieure, avec la face inférieure de la couche 47, et entouré latéralement d'une couche en un isolant thermique 51. Autrement dit, Chaque cellule mémoire comprend un élément résistif 49 en contact avec la face inférieure de la couche 47 au niveau de l'emplacement de ladite cellule mémoire. Les éléments 49 sont par exemple séparés les uns des autres par la couche isolante 51. Par exemple, la couche 51 est en le même matériau que la couche 45. A titre d'exemple, la couche 51 est en carbonitrure de silicium. A titre d'exemple, l'élément chauffant 49 a, par exemple, une épaisseur comprise entre 30 nm et 170 nm, par exemple de l'ordre de 80 nm.

La couche 47 en le matériau à changement de phase est, par exemple surmontée par des pistes conductrices, ou métallisations, 53, par exemple en un matériau conducteur, par exemple en métal. A titre d'exemple, dans chaque cellule mémoire M, l'élément résistif 49 et la piste 53 forment respectivement une électrode inférieure et une électrode supérieure de la cellule mémoire M.

La couche 45 a de préférence une épaisseur, par exemple une épaisseur maximale, supérieure à l'épaisseur de la couche 47, par exemple supérieure à l'épaisseur de l'empilement comprenant l'élément résistif 49, la couche 47 et la couche 53. La couche 45 a de préférence une épaisseur, par exemple une épaisseur maximale, supérieure à l'épaisseur de la cellule mémoire M.

A titre d'exemple, les cellules mémoires M d'une même ligne de bits sont surmontées d'une même piste 53. En d'autres termes, les électrode supérieures 53 des cellules mémoires M d'une même ligne de bits sont interconnectées. Autrement dit, dans l'exemple des figures 1A et 1B

Chaque cellule mémoire M est par exemple recouverte par une couche d'isolation 55 protégeant, par exemple, la couche 47 de l'oxydation. La couche d'isolation 55 est par exemple en un nitrure, par exemple en nitrure de silicium. La couche 55 recouvre de préférence au moins partiellement la face supérieure de la couche 53 et recouvre par exemple au moins partiellement, de préférence entièrement, les parois latérales des couches 47, 51, 53 et des éléments 49.

Dans l'exemple des figures 1A et 1B, pour chaque cellule mémoire M, la zone 27 située à l'aplomb de ladite cellule mémoire M, la couche 15 (et la zone 29) et la couche 17 définissent un transistor bipolaire, ici de type PNP, de sélection de la cellule mémoire. Chaque cellule mémoire M est par exemple associée à un transistor bipolaire. Dans cet exemple, la région 27 constitue une région d'émetteur du transistor, la région 15 (et la zone 29) constitue une région de base du transistor et la couche 17 constitue une région de collecteur du transistor. A titre d'exemple, le collecteur est commun à tous les transistors de la matrice et est, par exemple, connecté à la masse. Dans cet exemple, la région de base 15 est commune à tous les transistors d'une même ligne de mots du circuit mémoire.

Chaque cellule mémoire M est connectée électriquement au transistor de sélection auquel elle est associée par l'intermédiaire d'un via conducteur 63 traversant toute l'épaisseur de l'empilement d'interconnexion 35. A titre d'exemple, le via 63 traverse l'ensemble des couches isolantes 39 et 37 de l'empilement d'interconnexion 35.

A titre d'exemple, le via 63 est en contact, par sa face supérieure, avec la face inférieure de l'élément résistif chauffant 49 de la cellule mémoire M. Le via 63 est par exemple en contact, par sa face inférieure, avec un autre via conducteur 65, lui-même en contact avec la face supérieure de la couche 25. Ainsi, le via 63 de chaque cellule mémoire M s'étend partiellement à travers la couche 45, plus précisément à travers la portion de la couche 45 située sous l'élément 48, et s'étend à travers l'empilement d'interconnexion 35, de préférence à travers tout l'empilement 35.

A titre d'exemple, pour chaque cellule mémoire M, le via 63 correspondant relie électriquement l'élément chauffant 49 de la cellule mémoire à la région 27 sous-jacente, par l'intermédiaire d'un via 65.

Le via conducteur 63 est par exemple en un matériau métallique. Le via conducteur 63 est par exemple en tungstène. En variante, le via conducteur 63 est par exemple en cobalt ou en cuivre. Le via conducteur 63 a, par exemple, une largeur, prise dans le plan de la figure 1A et dans le plan de la figure 1B, comprise entre 40 nm et 100 nm, par exemple de l'ordre de 70 nm.

Le via conducteur 65 traverse par exemple la couche isolante 41. Le via conducteur 65 affleure, par exemple par sa face inférieure, la face inférieure de la couche isolante 41 et par sa face supérieure à la face supérieure de la couche isolante 41. Ainsi, le via 41 s'étend sur toute la hauteur de la couche 41. Le via conducteur 65 est par exemple en contact, par sa face inférieure, à la face supérieure de la couche 25 et plus particulièrement à la région 27. Le via conducteur 65 est par exemple en contact, par sa face supérieure, à la face inférieure du via conducteur 63. Le via conducteur 65 est par exemple en un matériau métallique, par exemple en tungstène.

Chaque niveau de l'empilement d'interconnexion 35, 36 comprend par exemple des vias conducteurs 69 et des pistes conductrices 71. Les pistes conductrices 71 affleurent la face supérieure de la couche 37 et s'étendent dans la couche 37. Les vias conducteurs 69 sont en contact avec un piste conductrice 71 du même niveau. Les vias conducteurs 69s'étendent de la face inférieure de la piste conductrice 71 du même niveau jusqu'à la face inférieure de la couche 39 du même niveau. Les pistes conductrices 71 et les vias 69 permettent ainsi de faire des liaisons électriques traversant les niveaux de l'empilement d'interconnexion. Les pistes conductrices 71 et les vias conducteurs 69 sont par exemple en métal, par exemple en cuivre ou en tungstène.

Plus précisément, des pistes conductrices 71a affleurent la face supérieure de la couche 37a et s'étendent dans la couche 37a. Des vias conducteurs 69a s'étendent des pistes 71a jusqu'à la face inférieure de la couche 39a, en traversant la couche 39a. Similairement, des pistes conductrices 71b, respectivement 71c, respectivement 71d, respectivement 71e, respectivement 71f, affleurent la face supérieure de la couche 37b, respectivement 37c, respectivement 37d, respectivement 37e, respectivement 37f, et s'étendent dans la couche 37b, respectivement 37c, respectivement 37d, respectivement 37e, respectivement 37f. Des vias conducteurs 69b, respectivement 69c, respectivement 69d, respectivement 69e, respectivement 69f, s'étendent des pistes 71b, respectivement 71c, respectivement 71d, respectivement 71e, respectivement 71f, jusqu'à la face inférieure de la couche 39b, respectivement 39c, respectivement 39d, respectivement 39e, respectivement 39f, en traversant la couche 39b, respectivement 39c, respectivement 39d, respectivement 39e, respectivement 39f.

A titre d'exemple, les pistes conductrices 71 s'étendent latéralement sur une surface comprise entre 60 nm par 60 nm et 100 nm par 100 nm, par exemple de l'ordre de 80 nm par 80 nm. A titre d'exemple, les pistes conductrices 71 s'étendent latéralement sur une surface supérieure à la surface des vias 69 et du via conducteur 63.

Chaque cellule mémoire M est reliée à une piste 71 et à un via conducteur 69 par un élément conducteur 68. De préférence, chaque cellule mémoire M est reliée aux pistes et vias conducteurs du niveau inférieur de l'empilement d'interconnexion 36, c'est-à-dire le niveau le plus proche de la couche 45.

Chaque élément 68 s'étend de la face supérieure de la couche 45 à la face supérieure de la couche 53. Chaque élément 68 traverse ainsi une portion de la couche 45 et la couche 55 de manière à être en contact avec la couche 53. Le dispositif 11 comprend par exemple un élément 68 pour chaque ligne de bit. Chaque élément 68 s'étend par exemple sur au moins une partie de la longueur de la couche 5, par exemple sur toute la longueur de la couche 53, par exemple au moins en regard de chaque cellule mémoire M.

Les éléments 68 sont par exemple en métal. Les éléments 68 sont par exemple en un matériau différent du matériau des pistes 71 et des vias 69.

A titre de variante, chaque élément 68 peut être remplacé par des vias conducteurs non représenté, par exemple en le même matériau que l'élément 68. Chaque vias non représenté s'étendrait, comme l'élément 68, de la face supérieure de la couche 53 à la face supérieure de la couche 45. Chaque cellule mémoire M serait située à l'aplomb d'un via conducteur non représenté.

Chaque élément 68 est par exemple en contact avec la face inférieure d'au moins un vias 69d, par exemple avec autant de vias 69d que la ligne de bits comprend de cellules mémoires M. Lesdits vias 69d en contact avec un même élément 68 sont de préférence reliés ensemble par une piste 71d. Ainsi, les électrodes supérieures des cellules mémoires d'une même ligne de bits sont reliées ensemble par une piste 71d de l'empilement d'interconnexion.

La couche 41 comprend des vias 66. La couche 41 comprend par exemple autant de vias 66 que la couche 25 comprend de région 29. Chaque via 66 est en contact d'une région 29. Autrement dit, chaque via 66 s'étend entre une région 29 et la face supérieure de la couche 41.

Les deuxièmes régions 29 de la couche 25 sont par exemple reliées à des pistes conductrices 71e ou 71f. Les pistes conductrices 71e ou 71f sont par exemple en cuivre. Les pistes conductrices 71e ou 71f correspondent par exemple aux reprises de contact des lignes de mots.

Chaque région 29 est reliée à une piste conductrice 71e ou 71f par un via 66, traversant la couche isolante 41, par une succession de vias 69 et de pistes conductrices 71 traversant l'empilement d'interconnexion 35, par un via conducteur 70, traversant la couche isolante 43 et la couche isolante 45, et par une succession de vias 69 et de pistes conductrices 71 traversant l'empilement d'interconnexion 36.

Autrement dit, dans l'exemple des figures 1A et 1B, chaque région 29 est en contact avec la face inférieure d'un via 66. La face supérieure dudit via 66 est en contact avec la face inférieure d'un via 69a, le via 69a étant en contact avec une piste 71a. La face supérieure de la piste 71a est en contact avec un via 69b, le via 69b étant en contact avec une piste 71b. La face supérieure de la piste 71b est en contact avec un via 69c, le via 69c étant en contact avec une piste 71c. La face supérieure de la piste 71c est en contact avec une face inférieure d'un via 70. La face supérieure du via 70 est en contact avec un via 69d, le via 69d étant en contact avec une piste 71d. La face supérieure de la piste 71d est en contact avec un via 69e, le via 69e étant en contact avec une piste 71e. La face supérieure de la piste 71e est en contact avec un via 69f, le via 69f étant en contact avec une piste 71f. Dans l'exemple des figures 1A et 1B, les régions 29 d'une même ligne de mots sont reliés entre eux par des pistes 71^{e} et 71f communes.

Les vias 70 s'étendent par exemple de la face supérieure de la couche 45 à la face supérieure d'une piste 71 située dans le niveau supérieur de l'empilement d'interconnexion 35, c'est-à-dire le niveau le plus proche de la couche 45. Autrement dit, chaque via 70 s'étend au moins sur toute la hauteur de la couche 45, de préférence sur la hauteur de la couche 45 et de la couche 43. Chaque via 70 a par exemple une hauteur supérieure à la hauteur des vias 69.

Chaque via 70 correspond par exemple à un unique via. Les parois latérales des vias 70 sont par exemple planes. Les vias 70 ne comprennent ainsi pas de paliers. Chaque via 70 a par exemple des dimensions latérales sensiblement constantes.

La présence de la couche 45, comprenant les cellules mémoires et les vias 70, et en particulier l'absence de piste conductrice dans la couche 45, permettent de diminuer les risques de capacité parasite et permet donc d'utiliser des matériaux différents pour la couche 45 et pour les couches de l'empilement 35.

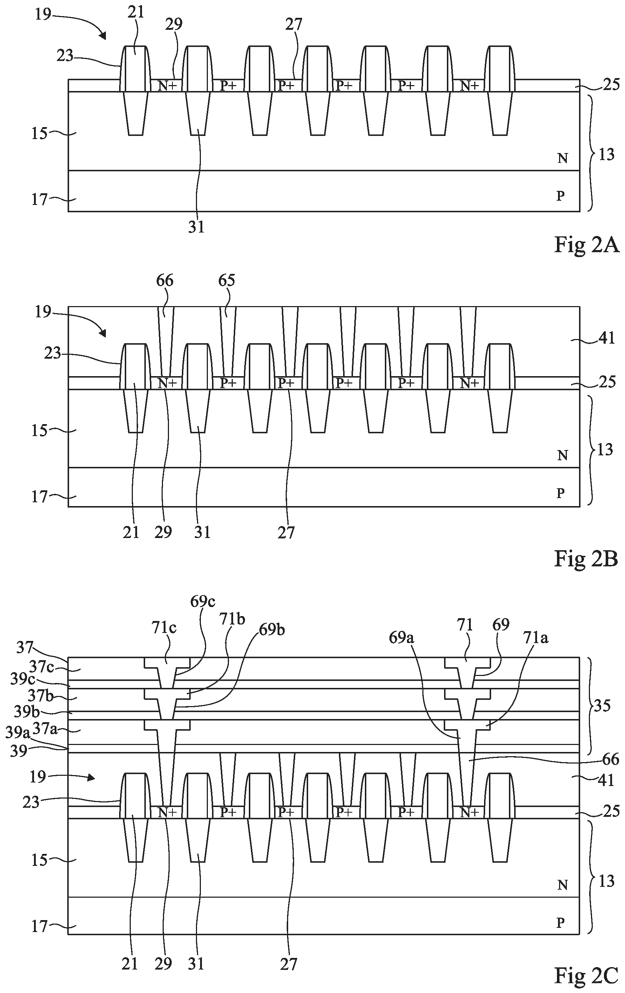

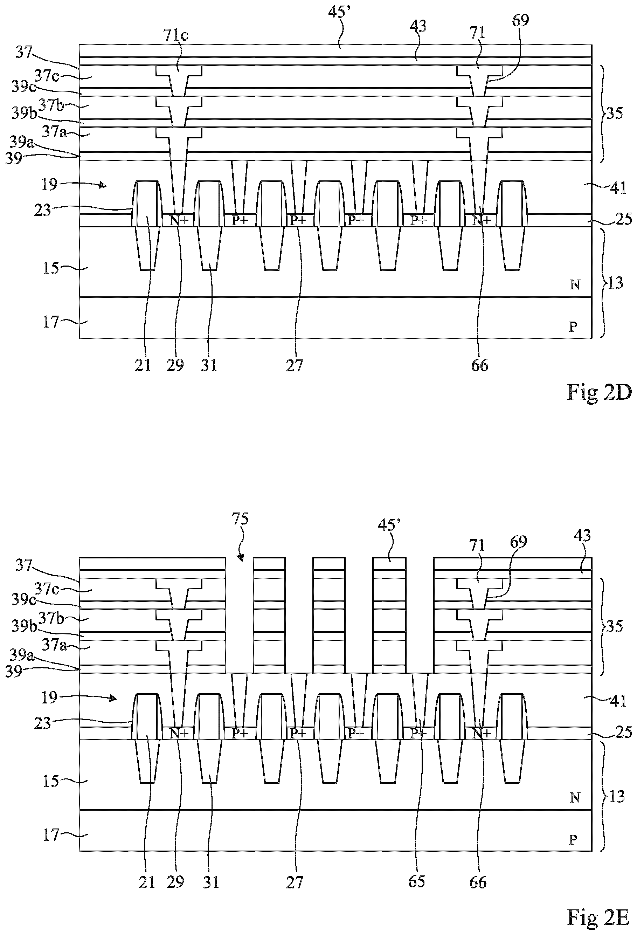

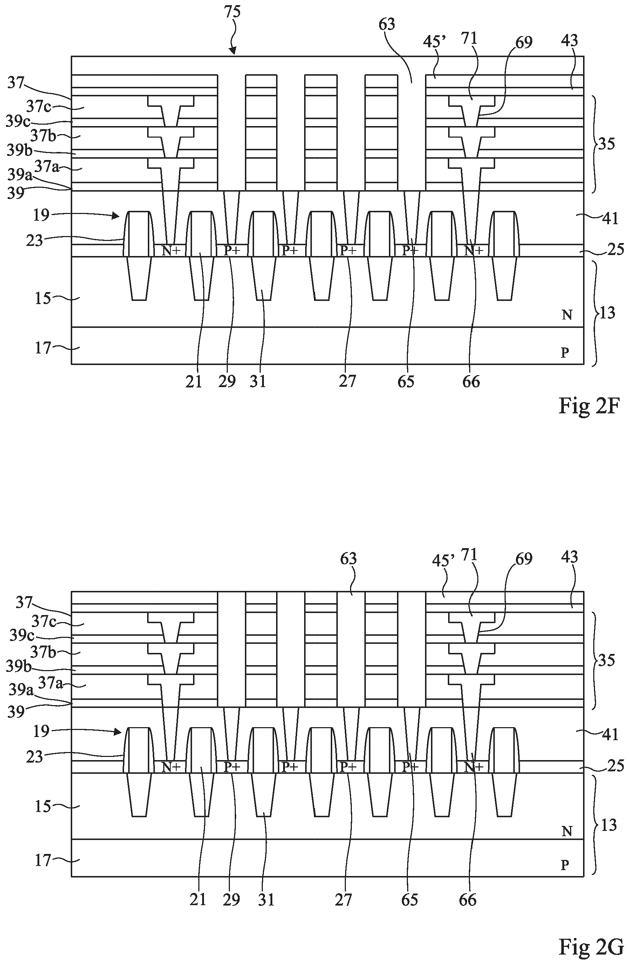

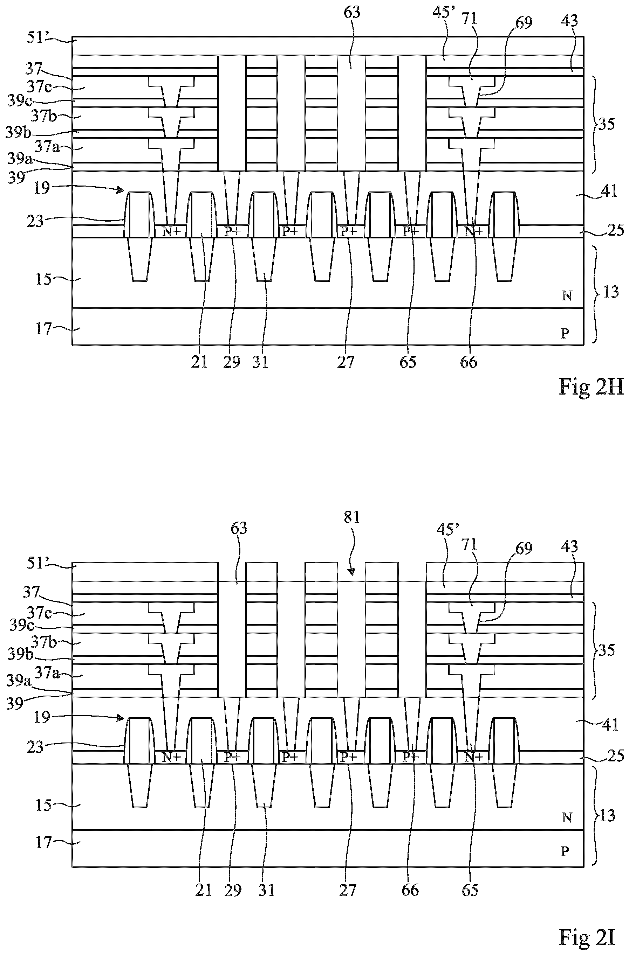

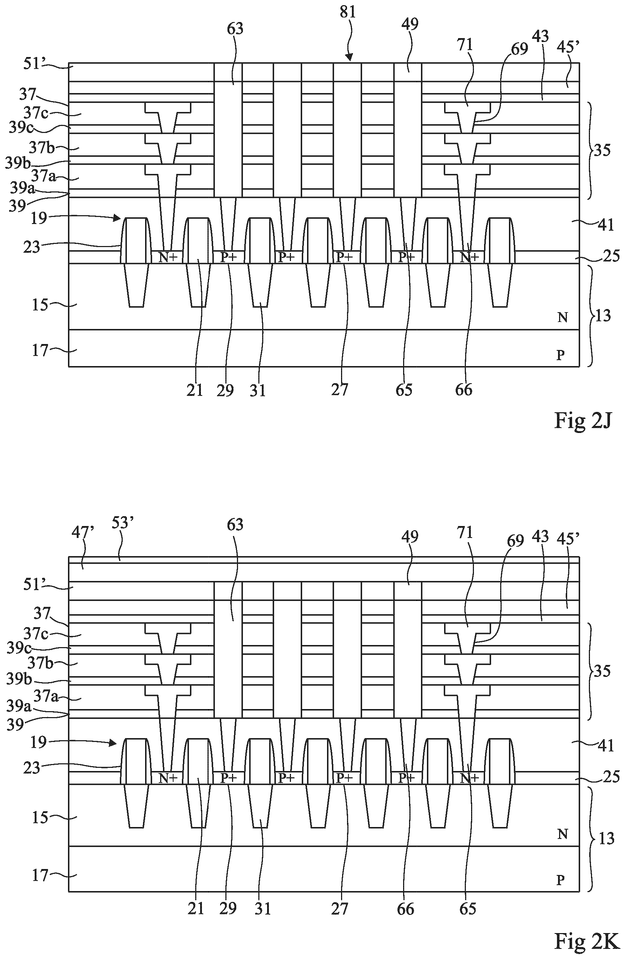

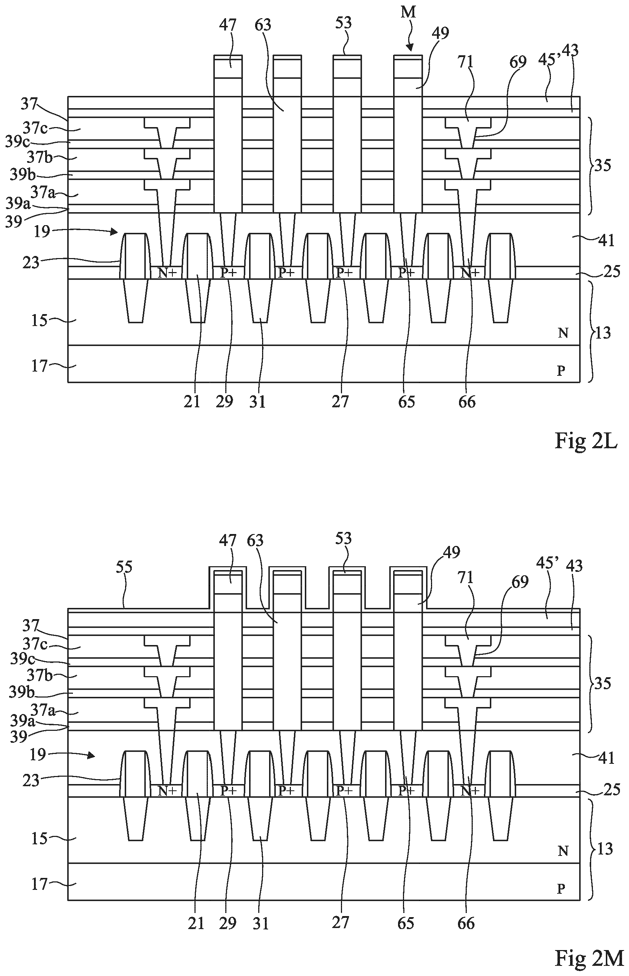

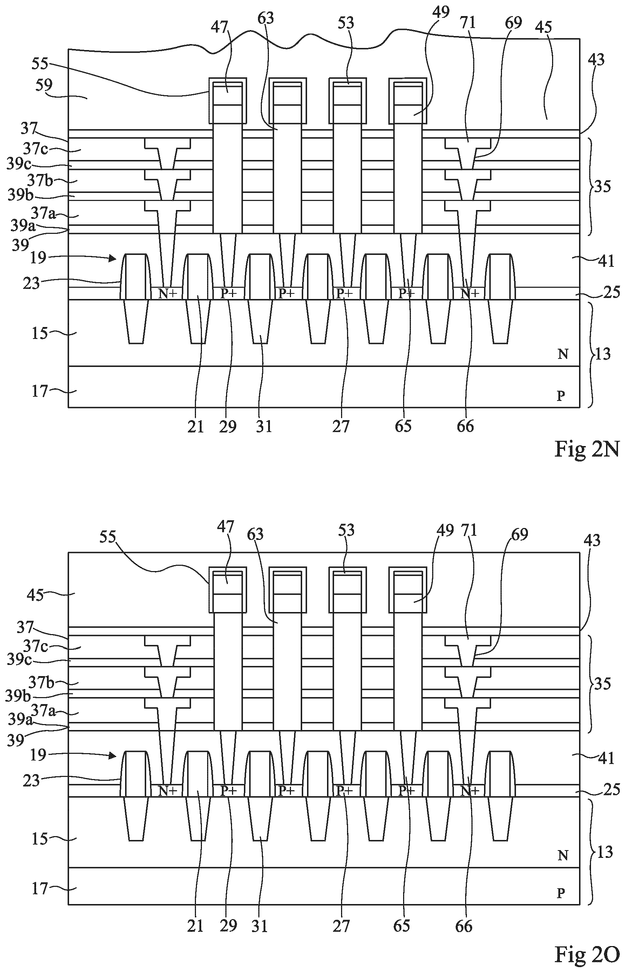

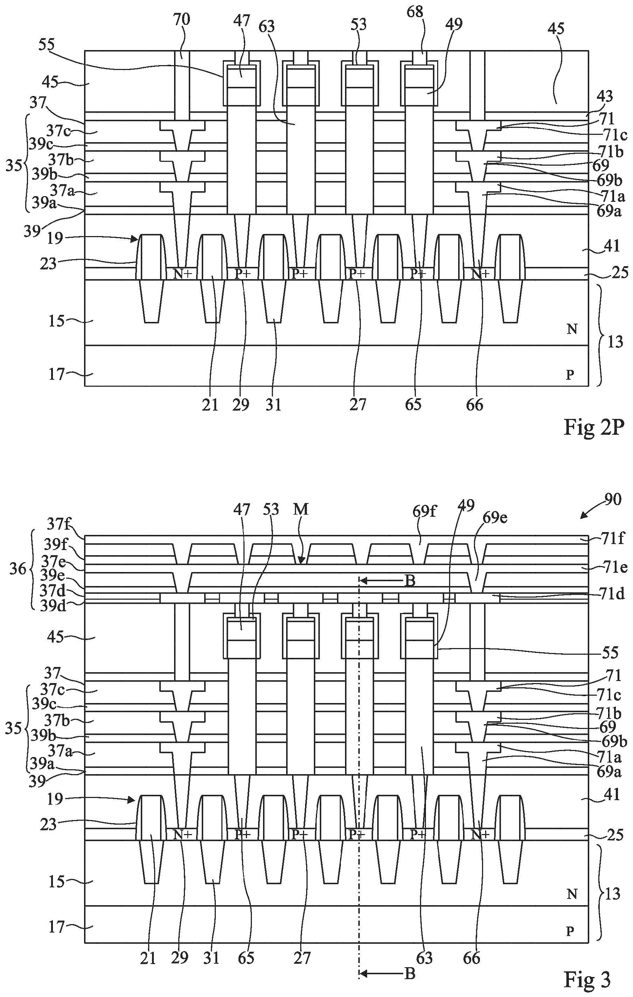

La figure 2A, la figure 2B, la figure 2C, la figure 2D, la figure 2E, la figure 2F, la figure 2G, la figure 2H, la figure 2I, la figure 2J, la figure 2K, la figure 2L, la figure 2M, la figure 2N, la figure 2O et la figure 2P représentent des étapes d'un exemple de procédé de fabrication du dispositif électronique illustré en figure 1A et en figure 1B.

La figure 2A illustre une vue en coupe, partielle et schématique, d'une structure de départ comportant sur le substrat semiconducteur 13 :
- la couche semiconductrice 25 comportant les régions 27 et 29 ; et
- les motifs de grilles 19 comportant une partie centrale 21 entourée d'espaceurs 23.

La figure 2B illustre une vue en coupe, partielle et schématique, d'une structure obtenue à l'issue d'une étape de formation de la couche isolante 41 sur la face supérieure de la structure de départ illustrée en figure 2A et de formation des vias 65 et 66 dans la couche isolante 41.

La figure 2C illustre une vue en coupe, partielle et schématique, d'une structure obtenue à l'issue d'une étape de formation de l'empilement d'interconnexion 35 sur la face supérieure de la structure illustrée en figure 2B et de formation des vias 69 et des pistes conductrices 71 dans l'empilement d'interconnexion 35. Cette étape est par exemple réalisée selon un procédé de damascène, par exemple selon un procédé double damascène, pendant lequel les vias conducteurs 69 et les pistes conductrices 71 d'un même niveau de l'empilement 35 sont formés simultanément.

Lors de cette étape, on vient, dans un premier temps, former la couche isolante 39a sur la face supérieure de la structure illustrée en figure 2B puis la couche isolante 37a sur la face supérieure de la couche isolante 39a.

Les couches 39a et 37a sont, dans un deuxième temps, gravées localement puis remplies en un matériau métallique de façon à former les vias conducteurs 69a et les pistes conductrices 71a.

Les différents niveaux supérieurs de l'empilement d'interconnexion 35 sont par exemple formés similairement l'un après l'autre.

La figure 2D illustre une vue en coupe, partielle et schématique, d'une structure obtenue à l'issue d'une étape de formation de la couche conductrice 43 sur la face supérieure de la structure illustrée en figure 2C et de formation d'une couche isolante 45' sur la face supérieure de la couche conductrice 43. La couche conductrice 43 est par exemple formée au contact de la couche isolante 37c et de la face supérieure de la piste conductrice 71c. A titre d'exemple, la couche isolante 45 est formée au contact de la couche conductrice 43.

La couche 45' correspond à la portion de la couche 45 située sous les cellules mémoires M. Ainsi, la couche 45 est en le même matériau que la couche 45 des figures 1A et 1B.

La figure 2E illustre une vue en coupe, partielle et schématique, d'une structure obtenue à l'issue d'une étape de formation d'ouvertures 75 traversant les couches 43 et 45' et l'empilement d'interconnexion 35 à l'aplomb des zones 27. A titre d'exemple, les ouvertures 75 débouchent sur les faces supérieures des vias 65. Les ouvertures 75 sont par exemple formées par gravure, par exemple par gravure humide. A titre d'exemple, les ouvertures 75 sont gravées à travers un masque de gravure non représenté en figure 2E. A titre d'exemple, le masque de gravure est en résine. Le masque de gravure est par exemple déposé et structuré avant l'étape de gravure des ouvertures 75 par photolithographie. A titre d'exemple, les ouvertures 75 peuvent ne pas avoir des flancs parfaitement rectilignes et verticaux. En effet, les couches 37 et 39 sont de natures différentes et n'ont donc pas la même vitesse de gravure. On peut ainsi prévoir que les ouvertures 75 soient plus larges dans les couches 37.

La figure 2F illustre une vue en coupe, partielle et schématique, d'une structure obtenue à l'issue d'une étape de dépôt d'une couche 77 en le matériau des vias 63 sur la face supérieure de la structure illustrée en figure 2E. Plus particulièrement, lors de cette étape, la couche 77 est formée de sorte qu'elle recouvre entièrement la face supérieure de la structure illustrée en figure 2E et plus précisément la face supérieure de la couche 45 et de façon à remplir les ouvertures 75.

La figure 2G illustre une vue en coupe, partielle et schématique, d'une structure obtenue à l'issue d'une étape de planarisation ou polissage de la face supérieure de la structure illustrée en figure 2F de façon à découvrir la face supérieure de la couche 45. En d'autres termes, lors de cette étape, on vient retirer l'excès de la couche 77 de façon à ne laisser subsister la couche 77 que dans les ouvertures 75 et ainsi former les vias 63. A titre d'exemple, cette étape est réalisée par planarisation mécanique, par exemple par planarisation mécanochimique (CMP, de l'anglais "Chemical Mechanical Planarization"). A l'issue de cette étape, les vias 63 affleurent la face supérieure de la couche 45'.

La figure 2H illustre une vue en coupe, partielle et schématique, d'une structure obtenue à l'issue d'une étape de dépôt d'une couche 51' sur la face supérieure de la structure illustrée en figure 2G. Plus particulièrement, la couche 51' est formée pleine plaque de façon à recouvrir d'ensemble de la face supérieure de la structure illustrée en figure 2G. La couche 51' recouvre, par exemple la face supérieure de la couche 45' et la face supérieure des vias 63. La couche 51' est en le même matériau que la couche 51 des figures 1A et 1B. La couche 51' a une épaisseur sensiblement égale à l'épaisseur de la couche 51 des figures 1A et 1B.

La figure 2I illustre une vue en coupe, partielle et schématique, d'une structure obtenue à l'issue d'une étape de retrait d'une partie de la couche 51' de façon à former des ouvertures 81 dans la couche 51'. A titre d'exemple, dans les ouvertures 81, la face supérieure des vias 63 est dévoilée. A titre d'exemple, le retrait localisé de la couche 51' est réalisé par gravure. A titre d'exemple, lors de cette étape, seules les parties de la couche 51' situées en vis-à-vis des vias 63 sont retirées. A titre d'exemple, les ouvertures 81 réalisées dans la couche 51' ont une forme correspondant à la former des éléments chauffants 49 illustrés en figures 1A et 1B. A titre d'exemple, les ouvertures 81 dans la couche 51' correspondent à des tranchées verticales. En variante, les ouvertures 81 dans la couche 51 ont une forme de "L" dans lequel la portion horizontale s'étend sur la face supérieure des vias 63 et la portion verticale correspond à une tranchée. A titre d'exemple, les ouvertures 81 sont locales et ne s'étendent pas dans la direction des lignes de bits.

La figure 2J illustre une vue en coupe, partielle et schématique, d'une structure obtenue à l'issue d'une étape de remplissage des ouvertures 81 de façon à former les éléments chauffants 49. A titre d'exemple, dans un premier temps, lors de cette étape, une couche en le matériau des éléments chauffants 49 est par exemple déposée sur la face supérieure de la structure illustrée en figure 2I et plus précisément sur la face supérieure de la couche 51 et dans les ouvertures 81. Lors de cette étape, dans un second temps, la face supérieure de la structure subie par exemple un polissage de façon à dévoiler la face supérieure de la couche 51 et ne laisser subsister la couche, en le matériau des éléments chauffants 49, que dans les ouvertures 81 et ainsi former les éléments chauffants 49.

La figure 2K illustre une vue en coupe, partielle et schématique, d'une structure obtenue à l'issue d'une étape de dépôt d'une couche 47', en le matériau à changement de phase de la couche 47 des figures 1A et 1B, et d'une couche conductrice 53', en le matériau de la couche 53 des figures 1A et 1B, sur la face supérieure de la structure illustrée en figure 2J. A titre d'exemple, lors de cette étape, on vient former une couche en le matériau à changement de phase 47' sur la face supérieure de la structure illustrée en figure 2J. La couche 47' en le matériau à changement de phase est par exemple formée en contact avec la couche 49. Lors de cette étape, on vient en outre former la couche 53' sur la face supérieure de la couche 47' en le matériau à changement de phase. La couche 53' est par exemple formée en contact avec la couche 47' en le matériau à changement de phase.

La figure 2L illustre une vue en coupe, partielle et schématique, d'une structure obtenue à l'issue d'une étape d'individualisation des lignes de bits des cellules mémoires M dans les couches 47' et 49 et dans les couches 51' et 53', de manière à former les éléments 49 et les couches 47, 51 et 53. Plus particulièrement, dans cette étape, on vient former en vis-à-vis des vias 63 d'une même ligne de bits, un empilement dans les couches 47 et 49 et dans la métallisation 53 de façon à définir les lignes de bits de cellules mémoires M. Cette étape est par exemple réalisée par gravure. A titre d'exemple, à l'issue de cette étape, la couche 51' subsiste entre les éléments chauffants 49 d'une même ligne de bits, formant la couche 51. A l'issue de cette étape, chaque cellule mémoire est ainsi formée d'un empilement de la couche 49, de la couche 47 et de la métallisation 53. La formation de cet empilement après et au-dessus du niveau d'interconnexion 35 permet avantageusement de s'affranchir des risques de contamination de la couche 47 de la cellule mémoire engendrés par la formation de l'empilement d'interconnexion et des différents niveaux métalliques 71 et 69.

La figure 2M illustre une vue en coupe, partielle et schématique, d'une structure obtenue à l'issue d'une étape de dépôt de la couche 55 sur la face supérieure de la structure illustrée en figure 2L. Plus particulièrement, lors de cette étape, on vient former la couche 55 sur la face supérieure de la couche 45' et sur la face supérieure et les flancs des empilements formés dans les couches 47 et 49 et la métallisation 53 définissant chacun une ligne de bits de cellules mémoires M.

La figure 2N illustre une vue en coupe, partielle et schématique, d'une structure obtenue à l'issue d'une étape retrait des portions de la couche 55 situées sur la face supérieure de la couche 45' et de dépôt d'une couche 59 sur la face supérieure de la structure illustrée en figure 2M. La couche 59 est en le même matériau que la couche 45. Plus particulièrement, lors de cette étape on vient par exemple former la couche 59 de sorte qu'elle recouvre l'ensemble de la couche 45' et l'ensemble de la couche 55. La couche 59 est par exemple déposée avec une épaisseur de sorte que les lignes de bits des cellules mémoires M définies en relation avec la figure 2L soient entièrement recouverts par la couche 59.

La figure 2O illustre une vue en coupe, partielle et schématique, d'une structure obtenue à l'issue d'une étape de planarisation de la face supérieure de la structure illustrée en figure 2N. Cette étape est par exemple réalisée par CMP. Les couches 59 et 45' forment alors la couche 45.

La figure 2P illustre une vue en coupe, partielle et schématique, d'une structure obtenue à l'issue d'une étape de formation des vias 68 et 70. A titre d'exemple, cette étape comprend une étape de gravure de la couche 45 de façon à y former des ouvertures qui sont, dans une étape successive remplies du matériau des vias 68 et 70.

Le procédé comprend ensuite des étapes non représentées. Plus précisément, le procédé comprend en outre la formation de l'empilement d'interconnexion 36 sur la structure résultant de l'étape de la figure 2P. La formation de l'empilement 36 est par exemple similaire à la formation de l'empilement 35.

La figure 3 représente un dispositif électronique 90 selon un autre mode de réalisation. Le dispositif 90 comprend les éléments du dispositif 11 des figures 1A et 1B qui ne seront pas décrit de nouveau en détails.

Le dispositif 90 diffère du dispositif 11 en ce que le dispositif 90 ne comprend pas les vias 69d, c'est-à-dire les vias conducteurs du niveau inférieur de l'empilement 36. Ainsi, les pistes 71d s'étendent de la face inférieure de la couche 39d à la face supérieure de la couche 37d. La face supérieure de chaque via 68 ou 70 est ainsi en contact avec la face inférieure d'une piste 71d.

Un avantage d'une telle structure est qu'il est possible de former les connexions du niveau de l'empilement 36 avec un niveau ayant une épaisseur faible.

Le procédé de fabrication du dispositif 90 est identique au procédé décrit en relation avec les figures 2A à 2P, à l'exception de la formation de l'empilement 36 qui ne comprend pas la formation des vias 69d.

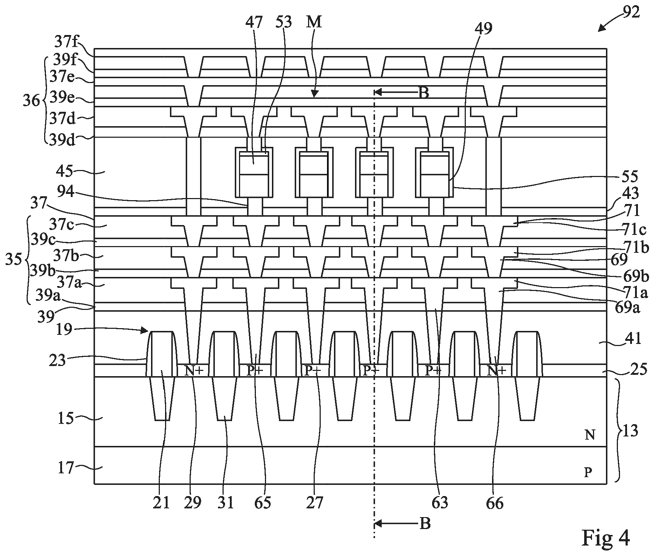

La figure 4 représente un dispositif électronique selon un autre mode de réalisation 92. Le dispositif 92 comprend les éléments du dispositif 11 des figures 1A et 1B qui ne seront pas décrit de nouveau en détails.

Le dispositif 92 diffère du dispositif 11 en ce que les vias 63 du dispositif 11 ont chacun été remplacés par une succession de vias conducteurs 69 et de pistes conductrices 71. Ainsi, des pistes 71a, 71b, 71c et des vias 69a, 69b, 69c sont situés en regard de chaque région 27 et en regard de chaque cellule mémoire M.

Le dispositif 92 comprend en outre des éléments, ou vias, 94. Les vias 94 sont par exemple en le matériau des vias 68 et 70. Chaque via 94 s'étend de la face supérieure d'une piste 71c à la face inférieure d'un élément 49. Ainsi, chaque via 94 traverse la couche 43 et la portion de la couche 45 située sous une cellule mémoire M.

Chaque cellule mémoire M est ainsi reliée à une région 27 par l'intermédiaire d'un via 94, de pistes 71 et de vias 69.

Le procédé de fabrication du dispositif 92 comprend les étapes du dispositif 11, c'est-à-dire les étapes décrites en relation avec les figures 2A à 2P. Le procédé de fabrication du dispositif 92 diffère du procédé des figures 2A à 2P en ce, dans l'étape de la figure 2C, les vias 69 et les pistes 71 situées en regard des régions 27 sont formées, par exemple en même temps que les pistes 71 et les vias 69 des mêmes niveaux. En outre, le procédé ne comprend pas les étapes des figures 2E à 2G. Le procédé comprend cependant, entre les étapes des figures 2D et 2H, la formation des vias 94, par exemple par un procédé damascène.

Un avantage des modes de réalisation décrits est que l'absence de pistes conductrices dans la couche 45 diminue le risque de capacités parasites, et il n'est ainsi pas nécessaire de former la couche 45 en un matériau ayant une constante diélectrique faible.

Un avantage des modes de réalisation décrits comprenant les vias 63 est que l'absence de pistes conductrices dans les couches 37 diminue le risque de capacités parasites, et il n'est ainsi pas nécessaire de former les couches 37 en un matériau ayant une constante diélectrique faible.

Un avantage des modes de réalisation décrits comprenant les vias 63 est qu'il permet de s'affranchir des contraintes de dimensionnement des niveaux de métaux pour l'intégration des cellules PCM, la surface des vias 63 pouvant être inférieure à la surface d'une piste 71 à la surface de l'empilement d'interconnexion 35. Ce mode de réalisation ne comprend avantageusement pas de vias 69 et de pistes 71.

Un autre avantage des modes de réalisation décrits comprenant les vias 63 est que la formation des cellules mémoires au-dessus des niveaux 36 permet de s'affranchir des risques de contamination de la couche PCM de la cellule mémoire engendrés par la formation de l'empilement d'interconnexion et des différents niveaux métalliques 71 et 69.

Encore un autre avantage des modes de réalisation décrits comprenant les vias 63 est qu'ils sont compatibles avec les procédés et les parties logiques connus, la partie logique n'étant pas impactée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique (11, 90, 92) comprenant :
- un substrat semiconducteur (13) dans lequel sont disposés des transistors de sélection ;
- un premier empilement d'interconnexion (35), disposé sur le substrat semiconducteur (13), comportant au moins un niveau, chaque niveau comportant des première et deuxième couches isolantes (37, 39), dans lesquels sont définis des pistes conductrices (71) et des premiers vias conducteurs (69) ;
- une troisième couche isolante (45), reposant sur le premier empilement d'interconnexion (35) ;
- un deuxième empilement d'interconnexion (36), disposé sur la troisième couche isolante (45), comportant au moins un niveau, chaque niveau comportant des première et deuxième couches isolantes (37, 39), dans lesquels sont définis les pistes conductrices (71) et les premiers vias conducteurs (69) ;
- une pluralité de cellules mémoires (M) disposées dans la troisième couche isolante (45) ; et
- au moins un deuxième via conducteur (70) s'étendant sur toute la hauteur de la troisième couche isolante, de manière à relier les pistes conductrices et les premiers vias conducteurs des premier et deuxième empilements (35, 36) .

2. Dispositif selon la revendication 1, dans lequel chaque cellule mémoire (M) comprend un élément résistif (49) en contact avec une quatrième couche (47) en un matériau à changement de phase, la septième couche étant surmonté par une cinquième couche conductrice (53).

3. Dispositif (11, 90, 92) selon la revendication 1 ou 2, dans lequel le substrat semiconducteur (13) comprend, à partir d'une face supérieure, une sixième couche semiconductrice (15) dopée d'un premier type de conductivité (N), située sur et en contact avec une septième couche semiconductrice (17) dopée d'un deuxième type de conductivité (P) opposé au premier type de conductivité.

4. Dispositif (11, 90, 92) selon la revendication 3, dans lequel le substrat semiconducteur (13) est surmonté par une huitième couche semiconductrice (25) comportant des premières zones (27) dopées du deuxième type de conductivité (P), chacune des premières zones de la huitième couche semiconductrice (25) étant reliée à une cellule mémoire (M).

5. Dispositif (11) selon la revendication 4, dans lequel la sixième couche semiconductrice (15), la septième couche semiconductrice (17) et les premières zones (27) de la sixième couche semiconductrice (25) constituent les transistors de sélection.

6. Dispositif selon la revendication 4 ou 5, dans lequel la huitième couche semiconductrice (25) comporte des deuxièmes zones (29) dopées du premier type de conductivité (N), chacune des deuxièmes zones (29) de la huitième couche semiconductrice (25) étant reliée à un ensemble de premiers vias conducteurs (69) et de pistes conductrices (71) traversant l'empilement d'interconnexion (35).

7. Dispositif selon l'une quelconque des revendications 4 à 6, dans lequel chacune des premières zones (27) de la huitième couche semiconductrice (25) est reliée à une cellule mémoire (M) par un unique troisième via (63) s'étendant sur toute la hauteur du premier empilement (35).

8. Dispositif selon les revendications 2 et 7, dans lequel chaque troisième via est en contact avec l'élément résistif de la cellule mémoire.

9. Dispositif selon l'une quelconque des revendications 4 à 6 et selon la revendication 2, dans lequel chacune des premières zones (27) de la huitième couche semiconductrice (25) est reliée à une cellule mémoire par des vias conducteurs (69) et des pistes conductrices (71) du premier réseau d'interconnexion (35) et par un quatrième via (94) s'étendant dans la troisième couche (45) et étant en contact avec l'élément résistif de la cellule mémoire, chaque quatrième via étant en le même matériau que les deuxièmes vias (70).

10. Dispositif selon l'une quelconque des revendications 1 à 9, dans lequel la troisième couche (45) est en un matériau différent des matériaux des première et deuxième couches isolantes (37, 39).

11. Dispositif selon l'une quelconque des revendications 1 à 10, dans lequel le matériau de la troisième couche (45) a une constante diélectrique supérieure à ceux des matériaux des premières et deuxièmes couches.

12. Dispositif selon l'une quelconque des revendications 1 à 11, dans lequel la hauteur de la troisième couche (45) est supérieure aux hauteurs des niveaux des premier et deuxième empilements (35, 36).

13. Dispositif selon l'une quelconque des revendications 1 à 12, dans lequel la hauteur de la troisième couche (45) est supérieure à la hauteur de la cellule mémoire (M).

14. Dispositif selon l'une quelconque des revendications 1 à 13, dans lequel le niveau du deuxième empilement le plus proche de la troisième couche comprend uniquement des pistes conductrices en contact avec le troisième via (70).

15. Dispositif selon l'une quelconque des revendications 1 à 14, dans lequel les pistes conductrices (71) des premier et deuxième empilements (35, 36) s'étendent latéralement sur une surface supérieure à la surface des premiers vias conducteurs (69) du même niveau.

16. Dispositif selon l'une quelconque des revendications 1 à 15, dans lequel la troisième couche est en un unique matériau, les cellules mémoires étant entièrement dans la troisième couche.

17. Dispositif selon l'une quelconque des revendications 1 à 16, dans lequel la troisième couche ne comprend pas de piste conductrice.

18. Procédé de fabrication d'un dispositif électronique (11, 90, 92) comprenant :
- la formation d'un substrat semiconducteur (13) dans lequel sont disposés des transistors de sélection ;
- la formation d'un premier empilement d'interconnexion (35), disposé sur le substrat semiconducteur (13), comportant au moins un niveau, chaque niveau comportant des première et deuxième couches isolantes (37, 39), dans lesquels sont définis des pistes conductrices (71) et des premiers vias conducteurs (69) ;
- la formation d'une troisième couche isolante (45), reposant sur le premier empilement d'interconnexion (35) ;
- la formation d'une pluralité de cellules mémoires (M) disposées dans la troisième couche isolante (45) ;
- la formation d'un deuxième empilement d'interconnexion (36), disposé sur la troisième couche isolante (45), comportant au moins un niveau, chaque niveau comportant des première et deuxième couches isolantes (37, 39), dans lesquels sont définis les pistes conductrices (71) et les premiers vias conducteurs (69) ; et
- la formation d'au moins un deuxième via conducteur (70) s'étendant sur toute la hauteur de la troisième couche, de manière à relier les pistes conductrices et les premiers vias conducteurs des premier et deuxième empilements (35, 36) .
